# EUROPÄISCHE PATENTSCHRIFT

(11) **EP 1 893 010 B1**
(45) Veröffentlichungstag und Bekanntmachung des Hinweises auf die Patenterteilung: **01.09.2010**
(21) Anmeldenummer: 07111778.2
(22) Anmeldetag: 05.07.2007
(51) Int. Cl.: H05K 7/20, H01L 23/40, H01L 33/00

(54) **Kühlanordnung**
Cooling assembly
Système de refroidissement

(30) Priorität: 23.08.2006 DE 102006039506
(43) Veröffentlichungstag der Anmeldung: 27.02.2008
(73) Patentinhaber: Siemens Aktiengesellschaft, 80333 München (DE)
(72) Erfinder: Hajek, Richard, 1140, Wien (AT); Hofbauer, Edwin, 1120, Wien (AT)

(56) Entgegenhaltungen:
- DE-A1- 19 543 260
- DE-C1- 10 052 191
- DE-U1- 8 707 370
- US-A- 5 321 582

## Beschreibung

Die Erfindung betrifft eine Kühlanordnung, welche zumindest ein zu kühlendes elektronisches Bauteil umfasst, mit einem ersten Gehäuseteil, welcher als Kühlkörper ausgebildet ist und an welchem das elektronische Bauteil anliegt sowie einem zweiten Gehäuseteil, welcher gegenüber dem ersten Gehäuseteil in einer vorgegebenen Montageposition angeordnet ist.

In vielen elektronischen Geräten sind elektronische Bauteile enthalten, die Wärme erzeugen. Diese Wärme muss abgeführt werden, um die Temperatur des elektronischen Bauteils in Grenzen zu halten. In der Regel geschieht dies über Kühlkörper, die flächig mit den zu kühlenden elektronischen Bauteilen in Kontakt sind und Wärme an die Umgebungsluft oder an ein im Kühlkörper zirkulierendes Kühlmedium abgeben.

Vor allem in der Leistungselektronik werden beispielsweise Schaltelemente auf diese Art gekühlt. Dabei kennt man nach dem Stand der Technik verschiedene Anordnungen um ein zu kühlendes elektronisches Bauteil mit einem Kühlkörper zu kontaktieren.

In der Gebrauchsmusterschrift DE 87 07 370 U1 ist eine Vorrichtung zum Befestigen eines elektronischen Bauelements an einem als Kühlblech ausgebildeten Kühlkörper beschrieben. Das an eine Leiterplatte gelötete Bauelement ist teilweise von einem Kunststoffkörper umgeben. Mittels einer auf den Kunststoffkörper wirkenden federnden Klammer wird das Bauelement mit seiner Kühlfläche gegen das Kühlblech gedrückt.

Die Patentschrift DE 100 52 191 beschreibt eine Kühlanordnung mit einer Kühlplatte und einer parallel zu dieser angeordneten Leiterplatte. Zwischen Leiterplatte und Kühlplatte sind zwei elektronische Bauelemente angeordnet, die unter Ausbildung eines flächigen Kontakts auf der Kühlplatte platziert sind und die mittels Anschlusselementen elektrisch mit der Leiterplatte kontaktiert sind. Ein an der Kühlplatte montiertes, metallisches Andrückelement mit einem Rahmen und wenigstens zwei innerhalb des Rahmens ausgebildeten Federzungen presst die elektronischen Bauelemente an die Kühlplatte.

Kühlkörper bilden in der Regel einen Teil eines Gehäuses, damit die Wärme an die Umgebung abgegeben werden kann.

Der Erfindung liegt die Aufgabe zugrunde, für eine Kühlanordnung der eingangs genannten Art eine Verbesserung gegenüber dem Stand der Technik anzugeben.

Erfindungsgemäß wird diese Aufgabe gelöst durch eine Kühlanordnung gemäß Anspruch 1.

Der zumindest eine Fortsatz im zweiten Gehäuseteil ersetzt zusätzliche Befestigungselemente wie Klammern oder dergleichen, wodurch die erfindungsgemäße Anordnung gegenüber bekannten Anordnungen billiger und einfacher zu montieren ist. Der Materialbedarf sinkt und die Fixierung der zu kühlenden Bauelemente am Kühlkörper erfolgt in einem Arbeitsschritt mit dem Zusammensetzen der Gehäuseteile. Ein eigener Arbeitsschritt zur Fixierung der zu kühlenden Bauelemente an einem Kühlkörper entfällt.

Dabei ist es von Vorteil, wenn der zumindest eine Fortsatz des zweiten Gehäuseteils mittels eines Befestigungselements mit dem ersten Gehäuseteil verbunden ist. Das Befestigungselement dient dabei der Verbindung des ersten mit dem zweiten Gehäuseteil und hat die zusätzliche Wirkung, die Anpresskraft des Fortsatzes auf ein zu kühlendes elektronisches Bauteil zu erhöhen. Damit verbessert sich die thermische Verbindung zwischen dem elektronischen Bauteil und dem Kühlkörper und die entstehende Wärme kann bei geringerem Temperaturgefälle in den Kühlkörper abgeleitet werden.

Dabei ist es günstig, wenn das Befestigungselement als Verschraubung ausgebildet ist. Das Gehäuse ist somit sicher geschlossen und kann im Bedarfsfall auf einfache Weise wieder geöffnet werden.

Von Vorteil ist es des Weiteren, wenn der zumindest eine Fortsatz des zweiten Gehäuseteils als elastische Lasche ausgebildet ist. Die Möglichkeit des Zurückfederns der Lasche während des Zusammenführens der beiden Gehäuseteile vereinfacht den Montagevorgang. Dabei kann der Rand der Lasche, welcher während der Montage über das elektronische Bauteil gleitet, eine Aufkantung zur besseren Aufnahme des elektronischen Bauteils aufweisen.

Eine vorteilhafte Ausprägung der Erfindung sieht vor, dass der zumindest eine Fortsatz des zweiten Gehäuseteils auf der dem zumindest einen elektronischen Bauteil zugewandten Seite eine Noppe aufweist, mittels welcher der zumindest eine Fortsatz im montierten Zustand eine punktuelle Anpresskraft auf das zumindest eine elektronische Bauteil ausübt. Durch die punktuelle Krafteinwirkung im Berührungspunkt von Noppenkuppe und elektronischem Bauteil wird erreicht, dass das elektronische Bauteil mit seiner Kühlfläche ganzflächig gegen den Kühlkörper gedrückt und ein etwaiges Verkanten verhindert wird.

Vorteilhaft ist es auch, wenn der zumindest eine Fortsatz des zweiten Gehäuseteils ein seitliches Distanzelement aufweist, welches bei asymmetrischer Anordnung des zumindest einen elektronischen Bauteils gegenüber dem zumindest einen Befestigungselement als Distanzhalter zwischen dem zumindest einen Fortsatz und dem als Kühlkörper ausgebildeten ersten Gehäuseteil dient. Durch diese Ausbildung wird ein Verkanten des Fortsatzes verhindert, falls nur ein elektronisches Bauteil vorhanden ist und die Kraftlinie des Befestigungselements außerhalb der Kontaktfläche des elektronischen Bauteils verläuft. Der Fortsatz stützt sich dann zusätzlich über das Distanzelement gegen den Kühlkörper ab.

Dabei ist es günstig, wenn das seitliche Distanzelement als seitliche Abwinkelung des als elastische Lasche ausgebildeten Fortsatzes ausgebildet ist. Vor allem bei einem zweiten Gehäuseteil aus Blech kann dann das Distanzelement durch einen einfachen Abkantvorgang gefertigt werden.

Günstigerweise ist das zumindest eine elektronische Bauteil an einem Schaltungsträger befestigt. Dieser Schaltungsträger ist innerhalb des Gehäuses angeordnet und hält den zumindest einen elektronischen Bauteil während des Schließens des Gehäuses in Position.

Die Erfindung wird nachfolgend in beispielhafter Weise unter Bezugnahme auf die beigefügten Figuren erläutert. Es zeigen in schematischer Darstellung:
- Fig. 1: Kühlanordnung mit geöffnetem Gehäuse
- Fig. 2: Schnittdarstellung der Kühlanordnung im montiertem Zustand

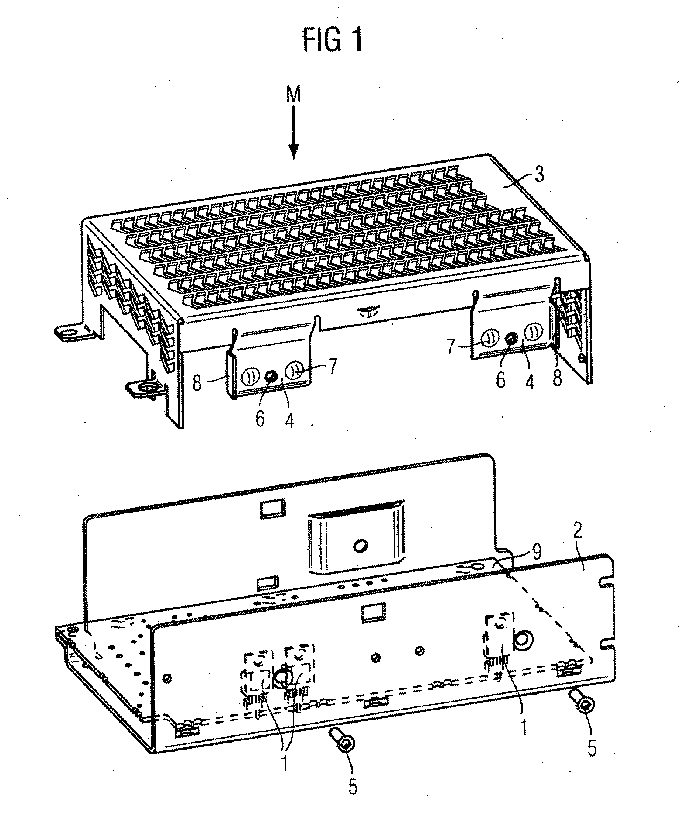

Figur 1 zeigt eine beispielhafte Kühlanordnung mit einem ersten Gehäuseteil 2, welcher als Kühlkörper ausgebildet ist, und einem zweiten Gehäuseteil 3, der pfeilförmige Lüftungsschlitze aufweist. Der zweite Gehäuseteil 3 ist der Übersichtlichkeit halber gegen die Montagerichtung M verschoben dargestellt. Der zweite Gehäuseteil 3 umfasst zwei als Laschen ausgebildete Fortsätze 4, wobei der erste Fortsatz 4 zur Befestigung von zwei zu kühlenden elektronischen Bauteilen 1 und der zweite Fortsatz 4 zur Befestigung eines zu kühlenden elektronischen Bauteils 1 vorgesehen ist.

Die zu kühlenden elektronischen Bauteile 1 sind an einem Schaltungsträger 9 befestigt, der innerhalb des ersten Gehäuseteils 2 angeordnet ist.

Während eines Montagevorgangs wird der zweite Gehäuseteil 3 in Montagerichtung M gegenüber dem ersten Gehäuseteil 2 in die vorgegebene Montageposition bewegt. Dieser Vorgang kann von Hand oder automatisiert ausgeführt sein. Dabei schieben sich die Fortsätze 4 hinter die zu kühlenden elektronischen Bauteile 1 und pressen diese gegen den als Kühlkörper ausgebildeten ersten Gehäuseteil 1.

Um die Anpresskraft der elektronischen Bauteile gegen den Kühlkörper zu erhöhen, sind die Befestigungselemente zum Verbinden der beiden Gehäuseteile 2, 3 in den als Laschen ausgebildeten Fortsätzen 4 angeordnet. Dabei ist für jeden Fortsatz 4 eine Verschraubung vorgesehen, wobei Schrauben 5 durch den ersten Gehäuseteil 1 geführt und in Gewindebohrungen 6 in den Fortsätzen 4 eingeschraubt sind. Beim Anziehen der Schrauben 5 werden die in den Schrauben 5 wirkenden Zugkräfte über die Fortsätze 4 auf die zu kühlenden elektronischen Bauteile 1 übertragen.

Bei einer asymmetrischen Anordnung der zu kühlenden elektronischen Bauteile 1 gegenüber den Befestigungselementen 5, 6 wird ein Verkanten eines Fortsatzes 4 durch ein Distanzelement 8 verhindert. In Figur 1 ist pro Fortsatz 4 ein Distanzelement 8 als Abkantung der als Lasche ausgebildeten Fortsätze 4 dargestellt. Der nur ein elektronisches Bauteil 1 haltende Fortsatz 4 stützt sich über das Distanzelement 8 gegen den ersten Gehäuseteil 2 ab.

Die Fortsätze 4 weisen zudem für jedes zu befestigende elektronische Bauteil 1 eine Noppe 7 auf, welche im montierten Zustand zentrisch auf der Andrückfläche eines elektronischen Bauteils 1 aufliegt. Mit diesen Noppen 7 werden im montierten Zustand punktförmige Kräfte auf die elektronischen Bauteile 1 übertragen und so ein Verkanten derselben verhindert.

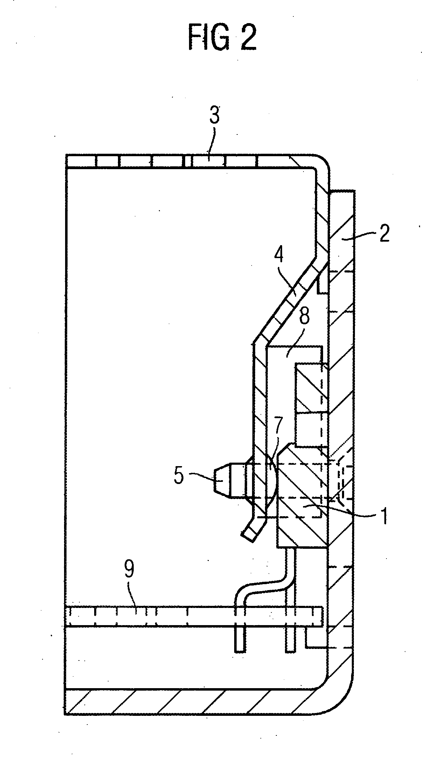

In Figur 2 ist ein seitlicher Schnitt durch einen als Lasche ausgebildeten Fortsatz 4 im montierten Zustand dargestellt. Der als Lasche ausgebildete Fortsatz 4 weist dabei auf der unteren Kante eine vom elektronischen Bauteil 1 abgewandte Aufkantung auf, wodurch der Fortsatz 4 während der Montage besser über das elektronische Bauteil geschoben werden kann.

Das Befestigungselement mit der Schraube 5 liegt in der gleichen Ebene wie die Noppe 7, die eine punktförmige Kraft auf das elektronische Bauteil 1 ausübt. Während des Montagevorgangs wird das elektronische Bauteil 1 durch die Befestigung auf dem Schaltungsträger 9 in Position gehalten, wobei sich dieser Schaltungsträger 9 gegen den ersten Gehäuseteil 2 abstützt.

Ist eine Positionierung mittels eines Schaltungsträgers 9 nicht möglich, können die zu kühlenden elektronischen Bauteile 1 während der Montage auch durch geeignete Montagehalterungen in Position gehalten werden.

## Patentansprüche

1. Kühlanordnung, welche zumindest ein zu kühlendes elektronisches Bauteil (1) umfasst, mit einem ersten Gehäuseteil (2), welcher als Kühlkörper ausgebildet ist und an welchem das elektronische Bauteil (1) anliegt sowie einem zweiten Gehäuseteil (3), welcher gegenüber dem ersten Gehäuseteil (2) in einer vorgegebenen Montageposition angeordnet ist, wobei der zweite Gehäuseteil (3) zumindest einen Fortsatz (4) aufweist, welcher das zumindest eine elektronische Bauteil (1) im montierten Zustand gegen den als Kühlkörper ausgebildeten ersten Gehäuseteil (2) drückt, **dadurch gekennzeichnet, dass** der zumindest eine Fortsatz (4) des zweiten Gehäuseteils (3) mittels eines Befestigungselements (5, 6) direkt mit dem ersten Gehäuseteil (2) verbunden ist.

2. Kühlanordnung nach Anspruch 1, **dadurch gekennzeichnet, dass** das Befestigungselement (5, 6) als Verschraubung ausgebildet ist.

3. Kühlanordnung nach einem der Ansprüche 1 bis 2, **dadurch gekennzeichnet, dass** der zumindest eine Fortsatz (4) des zweiten Gehäuseteils (3) als elastische Lasche ausgebildet ist.

4. Kühlanordnung nach einem der Ansprüche 1 bis 3, **dadurch gekennzeichnet, dass** der zumindest eine Fortsatz (4) des zweiten Gehäuseteils (3) auf der dem zumindest einen elektronischen Bauteil (1) zugewandten Seite eine Noppe (7) aufweist, mittels welcher der zumindest eine Fortsatz (4) im montierten Zustand eine punktuelle Anpresskraft auf das zumindest eine elektronische Bauteil (1) ausübt.

5. Kühlanordnung nach einem der Ansprüche 1 bis 4, **dadurch gekennzeichnet, dass** der zumindest eine Fortsatz (4) des zweiten Gehäuseteils (3) ein seitliches Distanzelement (8) aufweist, welches bei asymmetrischer Anordnung des zumindest einen elektronischen Bauteils (1) gegenüber dem zumindest einen Befestigungselement (5, 6) als Distanzhalter zwischen dem zumindest einen Fortsatz (4) und dem als Kühlkörper ausgebildeten ersten Gehäuseteil (2) dient.

6. Kühlanordnung nach Anspruch 3 und 5, **dadurch gekennzeichnet, dass** das seitliche Distanzelement (8) als seitliche Abwinkelung des als elastische Lasche ausgebildeten Fortsatzes (4) ausgebildet ist.

7. Kühlanordnung nach einem der Ansprüche 1 bis 6, **dadurch gekennzeichnet, dass** das zumindest eine elektronische Bauteil (1) an einem Schaltungsträger (9) befestigt ist.

## Claims

1. Cooling arrangement which comprises at least one electronic component (1) requiring to be cooled, said cooling arrangement having a first housing part (2) which is embodied as a heat sink and on which the electronic component (1) bears, and having a second housing part (3) which is disposed in a predefined assembly position opposite the first housing part (2), wherein the second housing part (3) has at least one extension (4) which presses the at least one electronic component (1) against the first housing part (2) embodied as a heat sink in the assembled state, **characterised in that** the at least one extension (4) of the second housing part (3) is connected directly to the first housing part (2) by means of a fastening element (5, 6).

2. Cooling arrangement according to claim 1, **characterised in that** the fastening element (5, 6) is embodied as a screw connection.

3. Cooling arrangement according to one of claims 1 to 2, **characterised in that** the at least one extension (4) of the second housing part (3) is embodied as a resilient strap.

4. Cooling arrangement according to one of claims 1 to 3, **characterised in that** on the side facing the at least one electronic component (1) the at least one extension (4) of the second housing part (3) has a stud (7) by means of which the at least one extension (4) exerts a contact force at a specific point on the at least one electronic component (1) in the assembled state.

5. Cooling arrangement according to one of claims 1 to 4, **characterised in that** the at least one extension (4) of the second housing part (3) has a lateral spacing element (8) which serves as a spacer between the at least one extension (4) and the first housing part (2) embodied as a heat sink in the case of an asymmetrical arrangement of the at least one electronic component (1) in relation to the at least one fastening element (5, 6).

6. Cooling arrangement according to claim 3 and 5, **characterised in that** the lateral spacing element (8) is embodied as a lateral angular offset of the extension (4) embodied as a resilient strap.

7. Cooling arrangement according to one of claims 1 to 6, **characterised in that** the at least one electronic component (1) is mounted on a circuit substrate (9).

## Revendications

1. Dispositif de refroidissement qui comprend au moins un composant ( 1 ) électronique à refroidir, comprenant une première partie ( 2 ) de boîtier, qui est constituée en dissipateur de chaleur et sur laquelle s'applique le composant ( 1 ) électronique, ainsi qu'une partie ( 3 ) de boîtier, qui est disposée dans une position de montage prescrite par rapport à la première partie ( 2 ) de boîtier, dans lequel la deuxième partie ( 3 ) de boîtier a au moins un prolongement ( 4 ) qui repousse le au moins un composant électronique à l'état monté sur la première partie ( 2 ) de boîtier constituée en dissipateur de chaleur, **caractérisé en ce qu'**au moins un prolongement ( 4 ) de la deuxième partie ( 3 ) de boîtier est assemblée directement à la première partie ( 2 ) de boîtier au moyen d'un élément ( 5, 6 ) de fixation.

2. Dispositif de refroidissement suivant la revendication 1, **caractérisé en ce que** l'élément ( 5, 6 ) de fixation est réalisé sous la forme d'un vissage.

3. Dispositif de refroidissement suivant l'une des revendications 1 à 2, **caractérisé en ce qu'**au moins un prolongement ( 4 ) de la deuxième partie ( 3 ) du boîtier est réalisé sous la forme d'un crampon élastique.

4. Dispositif de refroidissement suivant l'une des revendications 1 à 3, **caractérisé en ce qu'**au moins un prolongement ( 4 ) de la deuxième partie ( 3 ) du boîtier a, au côté tourné vers le au moins un composant ( 1 ) électronique, un bossage ( 7 ) au moyen duquel le au moins un prolongement ( 4 ) exerce à l'état monté une force de pression sur le au moins un composant ( 1 ) électronique.

5. Dispositif de refroidissement suivant l'une des revendications 1 à 4, **caractérisé en ce que** le au moins un prolongement ( 4 ) de la deuxième partie ( 3 ) du boîtier comporte un élément ( 8 ) latéral d'entretoisement qui, pour un agencement dissymétrique du au moins un composant ( 1 ) électronique par rapport au au moins un élément ( 5, 6 ) de fixation, sert d'entretoise entre le au moins un prolongement ( 4 ) et la première partie ( 2 ) du boîtier constitué en dissipateur de chaleur.

6. Dispositif de refroidissement suivant l'une des revendications 3 et 5, **caractérisé en ce que** l'élément ( 8 ) latéral d'entretoisement est constitué sous la forme d'une équerre latérale du prolongement ( 4 ) constituée en crampon élastique.

7. Dispositif de refroidissement suivant l'une des revendications 1 à 6, **caractérisé en ce qu'**au moins un composant ( 1 ) électronique est fixé à un support ( 9 ) de circuit.
